Europäisches Patentamt

European Patent Office

Office européen des brevets

(11) Publication number: 0 345 400
A1

## (12) EUROPEAN PATENT APPLICATION

(21) Application number: 88401380.6

(51) Int. Cl.4: H01L 21/285 , H01L 21/60

(22) Date of filing: 08.06.88

The title of the invention has been amended (Guidelines for Examination in the EPO, A-III, 7.3).

(43) Date of publication of application:
13.12.89 Bulletin 89/50

(84) Designated Contracting States:
FR

(71) Applicant: L'AIR LIQUIDE, SOCIETE ANONYME POUR L'ETUDE ET L'EXPLOITATION DES PROCEDES GEORGES CLAUDE
75, Quai d'Orsay
F-75321 Paris Cédex 07(FR)

Applicant: ULVAC CORPORATION
2500 Hagisono
Chigasaki-253(JP)

(72) Inventor: Hirase, Ikuo
75, quai d'Orsay
F-75321 Paris Cedex 07(FR)
Inventor: Rufin, Denis
75, quai d'Orsay

F-75321 Paris Cedex 07(FR)
Inventor: Shack, Mickael
75, quai d'Orsay
F-75321 Paris Cedex 07(FR)
Inventor: Sumiya, Tooru
75, quai d'Orsay
F-75321 Paris Cedex 07(FR)
Inventor: Matsuura, Masamichi
75, quai d'Orsay
F-75321 Paris Cedex 07(FR)
Inventor: Ukishima, Sadayuki
75, quai d'Orsay
F-75321 Paris Cedex 07(FR)
Inventor: Shishikura, Masato
75, quai d'Orsay
F-75321 Paris Cedex 07(FR)

(74) Representative: Vesin, Jacques et al
L'AIR LIQUIDE, SOCIETE ANONYME POUR L'ETUDE ET L'EXPLOITATION DES PROCEDES GEORGES CLAUDE 75, quai d'Orsay
F-75321 Paris Cédex 07(FR)

(54) Selective CVD for maufacturing semiconductor devices.

(57) A selective CVD method in which a semiconductor wafer having a first surface from which a semiconductor or a metal is exposed and a second surface covered with a thick insulating film is placed in a CVD reaction chamber, and a source gas containing a halide of a high-melting point metal is introduced in said reaction chamber to perform a chemical vapor deposition, thereby selectively forming a high-melting point metal film on said first surface, characterized in that said semiconductor wafer is treated by dry etching using an etchant gas containing $NF_3$ during an interruption of the chemical vapor deposition or after completion of the chemical vapor deposition.

FIG.6

## Improved Selective CVD Applied to Manufacturing Process of Semiconductor Device

Detailed Description of the invention [Field of Industrial Application]

The present invention relates to selective CVD and, more particularly, to an improvement in selective CVD applied to a manufacturing process of a semiconductor device.

[Prior Art]

Selective CVD (chemical vapor deposition) is employed for forming thin films of high-melting point metals such as Ti, W, Mo, Ta, and the like, and is an important technique in the manufacturing process of LSIs of very high integration density. A case will be described below wherein a W film is formed. However, this description applies to cases wherein other high-melting point metal films are formed.

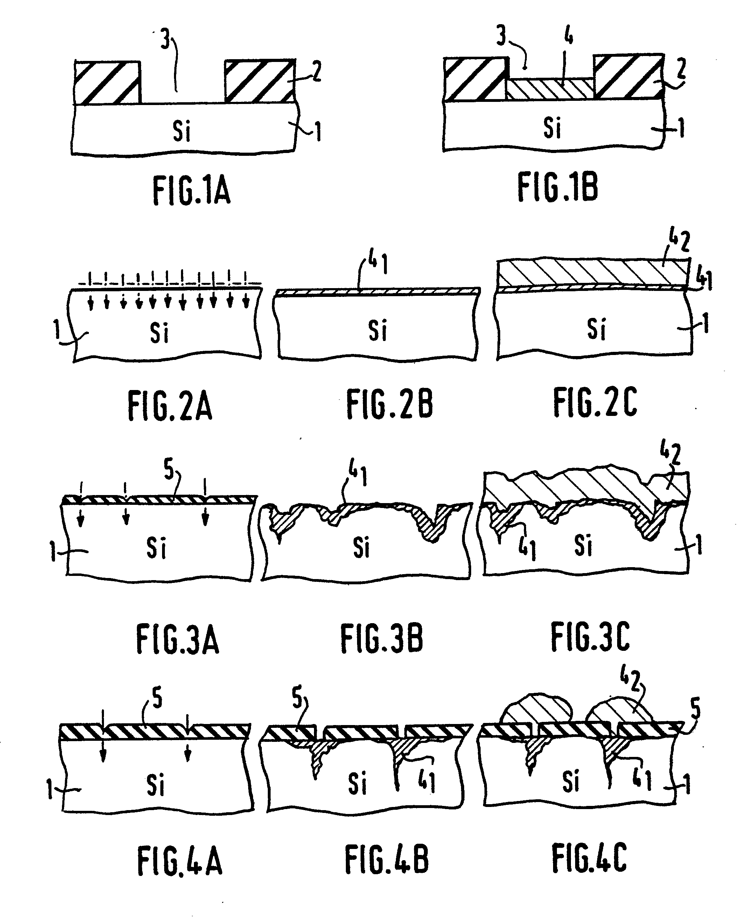

Fig. 1(A) shows a silicon wafer in which a surface of silicon substrate 1 is covered with thick $SiO_2$ film (field oxide film) 2, and contact hole 3 is formed in $SiO_2$ film 2. An operation for forming a W film on the silicon wafer using selective CVD is the same as in thermal CVD except that $WF_6$ is used as a source gas. However, as shown in Fig. 1(B), in this selective CVD, W film 4 is selectively deposited on only the exposed surface of silicon substrate 1, and no W film is deposited on the surface of field oxide film 2. This process is called selective CVD for this reason.

As described above, since selective CVD can form a predetermined W film pattern without PEP (photo engraving process), it is expected to be a micropatterning technique necessary for a VLSI process. More specifically, applications in wiring formation without requiring PEP, contact formation among wiring layers in a multilayered wiring technique, and the like are plausible.

The mechanism of selective CVD will be described below.

In selective CVD, the following two CVD reactions of the W occur.

$$2WF_6 + 3Si \rightarrow 3SiF_4 + 4W \qquad (1)$$
$$WF_6 + 3H_2 \rightarrow W + 6HF \qquad (2)$$

Of the two CVD reactions, reaction (1) requires an exposed Si surface. Therefore, this reaction naturally progresses on only the Si surface. The CVD by reaction 1) has a given limitation, and after the W film covering the Si surface is grown to a predetermined thickness, the reaction no longer progresses. On the other hand, the CVD by reaction (2) progresses not only on a semiconductor surface but on a metal surface, but does not progress on an insulating film surface such as an $SiO_2$ film. This is assumed to be caused since the metal or semiconductor surface provides a catalyst surface which promotes reaction (2).

For the above reason, formation of a W film by selective CVD is performed by either the following two methods.

(a) First, self-limiting CVD of W by reaction (1) is performed, and CVD by reaction (2) is then performed using the W film as a catalytic surface.

(b) From the beginning, CVD of W by reaction (2) is performed.

The conventional CVD methods have the following drawbacks.

The first drawback is insufficient selectivity in either of reactions (1) and (2). For this reason, in the case of Fig. 1(B), a W film is locally formed on the surface of field oxide film 2. This may cause undesirable short-circuiting among wiring layers.

It is considered that a decrease in selectivity in reaction (1) is caused such that $SiF_3$ produced in reaction (1) is decomposed on the surface of $SiO_2$ film 2 as shown in formula (3) below, thereby forming Si particles. More specifically, W is deposited on the surfaces of Si particles by reaction (1).

$$SiF_x \rightarrow Si + SiF_4 \qquad (3)$$

It is considered that a decrease in selectivity in reaction (2) is caused because of the same reason described above.

The second drawback is that preferable contact characteristics between silicon substrate 1 and W film 4 cannot be obtained when W film 4 is formed in the state shown in Fig. 1(B). In this case, the contact characteristics mean a contact resistance therebetween, an interface condition therebetween, and a morphology of W film 4. This problem is caused by a thin natural oxide film covering the exposed surface of silicon substrate 1, as will be described below.

When no natural oxide film on the exposed surface of silicon substrate 1 is present at all or when a natural oxide film thereon is uniform and very thin, $WF_6$ gas contacts the entire surface of silicon substrate 1, as shown in Fig. 2(A). For this reason, reaction (1) uniformly progresses on the surface of silicon substrate 1, and uniform W film $4_1$ is formed by self-limiting CVD. When CVD by formula (2) is successively performed, uniform W film $4_2$ is formed, as shown in Fig. 2(C). Therefore, in this case, an interface shape between silicon substrate 1 and W film 4, and a morphology of W film 4 are satisfactory. Since no increase in contact resistance due to the presence of a natural oxide film occurs, good contact characteristics can be obtained.

When the exposed surface of silicon substrate 1 is covered with a nonuniform thin natural oxide film, self-limiting CVD in reaction (1) progresses, as shown in Figs. 3(A) and 3(B). More specifically, since $WF_6$ gas preferentially reacts with Si at a thin portion of natural oxide film 5, nonuniform W film $4_1$ is formed and is locally filled in silicon substrate 1. Therefore, a good interface as shown in Fig. 2(B) cannot be obtained between silicon substrate 1 and W film $4_1$. Since the amount of Si consumed in the reaction of formula (1) is more than that of deposited W, a large unevenness is formed on the surface, as shown in Fig. 3(B). Therefore, after CVD of W by formula (2) is performed, the large unevenness remains on the surface of W film $4_2$.

When natural oxide film 5 has a larger thickness and is nonuniform, self-limiting CVD of W by reaction (1) progresses on only the portion in which the natural oxide film 5 is very thin and $WF_6$ gas can encroach into silicon substrate 1. Thus, W film $4_1$ is deeply formed only in that portion. Therefore, an interface condition between W film $4_1$ and silicon substrate 1 becomes poorer. If CVD by formula (2) is performed in the state shown in Fig. 4-(B), reaction (2) progresses only on a portion where W film $4_1$ is formed. Thus, particulate W film $4_2$ is formed. For this reason, even if CVD by reaction (2) is continued to form a continuous W film, the resultant W film is an aggregate of large particles, resulting in a poor morphology and a very large unevenness on the surface. If the unevenness on the W film surface is large, a good coverage cannot be obtained when a wiring layer of an Al film is formed thereon, thus increasing a contact resistance. As shown in Fig. 4(C), since natural film 5 is present between the W film and the silicon substrate, a contact resistance therebetween is increased. An increase in contact resistance due to the presence of the natural oxide film similarly occurs not only in a case wherein the underlying layer is made of silicon but also in a case wherein it is made of another semiconductor or a metal.

It should be noted that the degraded interface condition between W film 4 and silicon substrate 1 shown in Fig. 3(C) or 4(C) often brings about a fatal drawback in the manufacture of a semiconductor device. For example, when W film 4 used as an emitter electrode of a bipolar transistor is formed, an emitter junction is broken due to the deep encroachment of W film $4_1$ into silicon substrate 1.

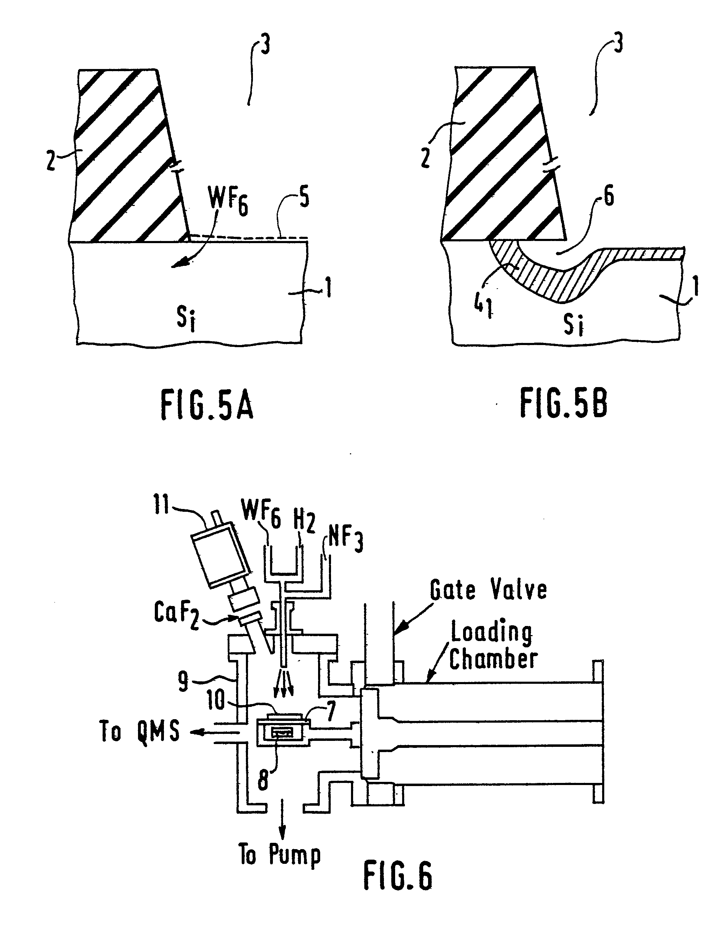

Figs. 5(A) and 5(B) show worst cases caused by the second drawback. That is, a silicon substrate surface exposed from the bottom surface of contact hole 3 is covered by relatively thick natural oxide film 5. In this case, since the natural oxide film is relatively weak at the periphery of the contact hole, $WF_6$ preferentially enters from this portion in self-limiting CVD of reaction (1). As a result, since Si-consumption by reaction (1) is more serious at the periphery of the contact hole than in other portions, cavity 6 shown in Fig. 5(B) is undesirably formed.

[Subjects to be Solved by the Invention]

The present invention has been made to eliminate the above drawbacks, and has the following subjects.

The first subject is to improve selectivity of selective CVD. More specifically, the first subject is to provide a method which can fill contact hole 3 with W film 4, while can greatly reduce and, preferably, perfectly remove W particles depositted on field oxide film 2 in Figs. 1(A) and 1(B).

The second subject is to improve contact characteristics between a semiconductor or metal underlying layer surface and a high-melting point metal film when the high-melting point metal film is formed on the semiconductor or metal underlying layer surface by selective CVD. More specifically, the second subject is to provide a method of performing selective CVD in a state wherein a natural oxide film covering the underlying layer surface is satisfactorily removed.

[Means for Achieving the Subjects]

In order to achieve the first subject, there is provided a selective CVD method (first invention) in which a semiconductor wafer having a first surface from which a semiconductor or a metal is exposed and a second surface covered with a thick insulating film is placed in a CVD reaction chamber, and a source gas containing a halide of a high-melting point metal is introduced in the reaction chamber to perform a chemical vapor deposition, thereby selectively forming a high-melting point metal film on the first surface, characterized in that the semiconductor wafer is treated by dry etching using an etchant gas containing $NF_3$ during an interruption of the chemical vapor deposition or after completion of the chemical vapor deposition.

In order to achieve the second subject of the present invention, there is provided a selective CVD method (second invention) in which a semiconductor wafer having a first surface from which a semiconductor or a metal is exposed and a second surface covered with a thick insulating film is placed in a CVD reaction chamber, and a source gas containing a halide of a high-melting point metal is introduced in the reaction chamber to perform a chemical vapor deposition, thereby selectively forming a high-melting point metal film on the first surface, characterized in that the semiconductor wafer is treated by dry etching using an etchant gas containing $NF_3$ prior to the chemical vapor deposition.

In either of the first and second inventions, the main point is to treat a semiconductor wafer by chemical dry etching using an etchant gas containing $NF_3$. More specifically, in the first invention, this treatment is performed as an intermediate treatment which is conducted during an interruption of the CVD process, or as a post treatment which is conducted after completion of the CVD process. Contrary to this, in the second invention, chemical dry etching using $NF_3$ is performed as a pre-treatment which is conducted prior to the beginning of the CVD process. Note that a combination of the first and second inventions is possible, i.e., chemical dry etching using $NF_3$ may be performed both as the pre-treatment and as the intermediate or post treatment.

In either of the first and second inventions, a chemical vapor deposition is preferably performed by low-pressure CVD (LPCVD). In either method, a high-melting point metal formed by selective CVD is not limited to W, but may be other high-melting point metals such as Ti, Mo, Ta, and the like, capable of selective CVD.

[Action of the Invention]

Dry etching using $NF_3$ in the first invention is performed in order to remove particles or a film of a high-melting point metal deposited on an insulating film due to insufficient selectivity of selective CVD reaction. More specifically, the particles or film of the high-melting point metal nonselectively deposited on the insulating film surface by formulas (3), and the like can be perfectly removed by a dry etching treatment of $NF_3$. In this case, a high-melting point metal selectively deposited on a semiconductor or metal surface by only reactions (1) and (2) is simultaneously etched. However, an amount of high-melting point metal nonselectively deposited on the insulating film surface is very small. Therefore, by selecting a treatment condition such as an etching time, only the high-melting point metal deposited on the insulating film surface can be substantially selectively removed. As a result, selectivity of selective CVD can be greatly improved, and a high-melting point metal nonselectively deposited on the insulating film surface can be greatly reduced or, preferably, perfectly removed.

The dry etching treatment using $NF_3$ in the first invention can be effectively performed in the middle of CVD process by interrupting the process, rather than after completion of CVD process. This is because a relatively large amount of deposited metal must be removed if etching is performed after completion of the CVD process, while only a very small amount of metal which has just begun to deposit is needed to be removed if etching is performed during the CVD process.

Dry etching using $NF_3$ in the second invention is performed to remove a natural oxide film covering the underlying layer surface (a semiconductor or metal surface) of selective CVD. Since the natural oxide film is removed by this pre-treatment, an increase in contact resistance between the high-melting point metal film formed by selective CVD and the underlying layer can be prevented. In addition, the problems described with reference to Figs. 2 to 5 can also be prevented, and good contact characteristics can be obtained.

In either of first and second inventions, the dry etching treatment using $NF_3$ can be performed in a CVD apparatus which is employed for selective CVD. The conditions of the treatment are appropriately selected in accordance with individual cases. However, normal etching conditions are as follows:

Total or Partial Pressure of $NF_3$: $10^{-2}$ to 100 Torr
Temperature: 50°C to 550°C
Etching time:
<First Invention>
Post Treatment: 10 sec. to 3 min.
Intermediate Treatment: 5 sec. to 1 min.
<Second Invention>
Pre-Treatment: 10 sec. to 3 min.

[Embodiment]

The present invention will be described hereinafter in detail by way of its examples.

Example 1 (First Invention)

As a sample to which selective CVD is to be applied, a silicon wafer having a structure shown in Fig. 1(A) was prepared. More specifically, $SiO_2$ film 2 having a thickness of 8000 Å was formed on a surface of silicon substrate 1. Many contact holes 3 each having a respective diameter of 2, 3 or 5μm was formed in $SiO_2$ film 2 by PEP and RIE (Reactive Ion Etching).

Selective CVD of the present invention was applied to the silicon wafer described above. The selective CVD was conducted using a cold-wall type LPCVD apparatus as shown in Fig. 6. A quartz hot plate 7 equipped with a halogen lamp 8 as a heating source was installed in a reaction chamber 9 of the LPCVD apparatus.

The silicon wafer sample 10 was placed on the hot plate 7 in the reaction chamber 9. Then, a rotary pump, a mechanical booster pump and a turbo molecular pump were sequentially used to evacuate the interior of the chamber. The internal pressure of the chamber was kept monitored using a capacitance manometer, and a pressure was maintained to be 0.1 to 1 Torr or less during a CVD process.

The silicon wafer 10 was then heated by the hot plate 7. During heating, the temperature of the silicon wafer 10 was monitored using an IR thermometer 11, so that the temperature of the wafer 10 was controlled to be 500°C during the CVD process. In general case, the temperature of wafer 10 is controlled to be 250°C to 650°C.

$WF_6$ serving as a tungsten source and $H_2$ as a reducing agent were introduced in the reaction chamber while heating the silicon wafer as described above, and selective CVD given by formula (2) described above was conducted. Argon or helium gas was used as a carrier gas. The flow rates of $WF_6$ and $H_2$ were as follows:
$WF_6$: 15 SCCM
$H_2$: 200 SCCM

After the CVD process was performed for about 1 minute, supply of the CVD gas was stopped. $NF_3$ was then introduced in the reaction chamber, and dry etching was performed under the following conditions:
Flow rate of $NF_3$: 100 SCCM
Pressure of $NF_3$ in reaction chamber: 0.3 Torr
Wafer Treatment: 350°C
Etching time: 1 minute

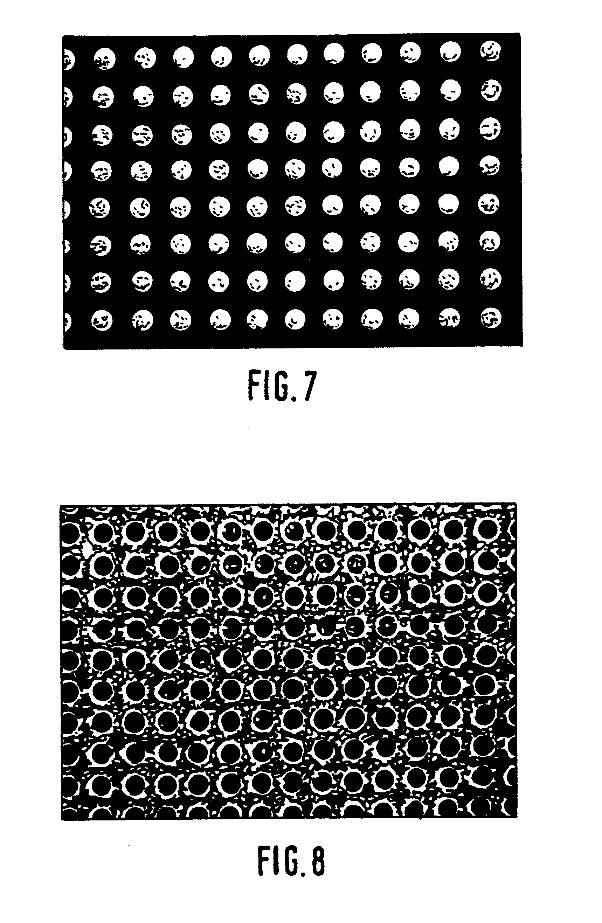

After completion of the dry etching process, the silicon wafer sample 10 was taken out from the chamber, and its surface was observed by an SEM. Fig. 7 shows the SEM photograph of the silicon wafer. As can be seen from Fig. 7, almost no W particles are deposited on the surface of $SiO_2$ film 2.

For the purpose of comparison, selective CVD was conducted following the same procedures as described above, except that dry etching using $NF_3$ was not conducted. Fig. 8 shows the SEM photograph of the obtained silicon wafer surface. As can be seen from Fig. 8, in this case, many W particles are deposited on the surface of $SiO_2$ film 2.

The above two results demonstrate that a insufficient selectivity of CVD reaction can be compensated for by dry etching, and as a result, satisfactory selectivity can be obtained.

Example 2 (Second Invention)

In this example, after selective CVD of W was performed for 1 minute, dry etching using $NF_3$ was performed for 20 seconds, and then, selective CVD of W was performed again for 1 minute. Excluding the above conditions, the silicon wafer was treated following the same procedures as in Example 1.

When the surface of the resultant silicon wafer was observed taking an SEM photograph, a photograph almost same to Fig. 7 is obtained. From this observation, it was found that almost no W particles were deposited on the surface of $SiO_2$.

Example 3 (Second Invention)

A silicon wafer sample identical to that used in Example 1 was placed in the reaction chamber of the LPCVD apparatus, and dry etching using $NF_3$ was performed under the following conditions:
Flow rate of $NF_3$: 100 SCCM
Pressure of $NF_3$ in reaction chamber: 0.3 Torr
Wafer Temperature: 350°C
Etching time: 1 minute

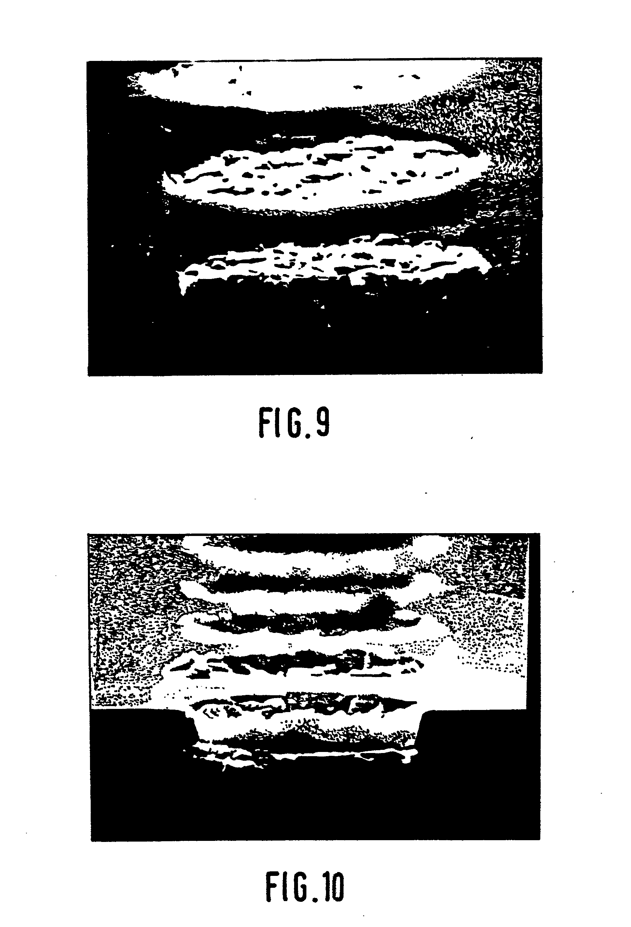

Selective CVD of W given by formula (1) was then performed under the following conditions:
$WF_6$: 10 SCCM
$H_2$: 200 SCCM
Pressure in reaction chamber: 0.3 Torr
Wafer Temperature: 600°C
Deposition time: 1 minute
Subsequently, selective CVD given by formula (2) was performed under the same conditions as in Example 1, thus forming a W film. Fig. 9 shows the SEM photograph of the surface of silicon wafer after the selective CVD process.

For the sake of comparison, selective CVD was performed following the same procedures as described above, except that a pre-treatment by $NF_3$ was not performed. Fig. 10 shows the SEM photograph in this case.

A comparison between Figs. 9 and 10 reveals the effect of dry etching by $NF_3$. More specifically, since a natural oxide film is not removed in Fig. 10, W deposition portion $4_1$ was formed in a deep portion of silicon substrate 1. In contrast to this, since the natural oxide film is removed in advance in Fig. 9, a good interface identical to that described with reference to Fig. 2 is formed.

In Fig. 10, particles constituting a W film are very large, and the morphology is impaired. In contrast to this, in Fig. 9, W particles are small, and a good morphology is obtained.

Although a contact resistance is not measured, since no natural oxide film is present in Fig. 9, the contact resistance is obviously low.

ÒEffect of the Inventionò

As described above, according to the present invention, selectivity of selective CVD can be improved, and contact characteristics of a metal film formed by the selective CVD can also be improved, thus providing noticeable effects.

4. Brief Description of the Drawings

Fig. 1 is a view for explaining selective CVD,

Figs. 2 to 5 are views for explaining problems in conventional selective CVD,

Fig. 6 is a shematic view of LPCVD apparatus employed in the present invention, and

Figs. 7 to 10 show SEM photographs demonstrating the effect of the present invention.

1...silicon substrate; 2...SiO$_2$ film; 3...contact hole; 4...W film

Claims

(1) A selective CVD method in which a semiconductor wafer having a first surface from which a semiconductor or a metal is exposed and a second surface covered with a thick insulating film is placed in a CVD reaction chamber, and a source gas containing a halide of a high-melting point metal is introduced in said reaction chamber to perform a chemical vapor deposition, thereby selectively forming a high-melting point metal film on said first surface, characterized in that said semiconductor wafer is treated by dry etching using an etchant gas containing NF$_3$ during an interruption of the chemical vapor deposition or after completion of the chemical vapor deposition.

(2) A selective CVD method in which a semiconductor wafer having a first surface from which a semiconductor or a metal is exposed and a second surface covered with a thick insulating film is placed in a CVD reaction chamber, and a source gas containing a halide of a high-melting point metal is introduced in said reaction chamber to perform a chemical vapor deposition, thereby selectively forming a high-melting point metal film on said first surface, characterized in that said semiconductor wafer is treated by dry etching using an etchant gas containing NF$_3$ prior to the beginning of the chemical vapor deposition.

(3) A selective CVD method in which a semiconductor wafer having a first surface from which silicon is exposed and a second surface covered with a thick insulating film is placed in a CVD reaction chamber, and a source gas containing WF$_6$ is introduced in said reaction chamber to perform a chemical vapor deposition, thereby selectively forming a high-melting point metal film on said first surface, characterized in that said semiconductor wafer is treated by dry etching using an etchant gas containing NF$_3$ prior to the beginning of the chemical vapor deposition.

(4) A method according to claim 2 or 3, characterized in that the dry etching using the gas containing NF$_3$ is also performed during an interruption of the chemical vapor deposition or after completion of the chemical vapor deposition.

FIG.1A

FIG.1B

FIG.2A

FIG.2B

FIG.2C

FIG.3A

FIG.3B

FIG.3C

FIG.4A

FIG.4B

FIG.4C

FIG.5A

FIG.5B

FIG.6

FIG.7

FIG.8

FIG.9

FIG.10

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 238 024 (FUJITSU) * Abstract; claim 6 * | 1 | H 01 L 21/285 |
| A | | 4 | H 01 L 21/60 |
| | --- | | |
| X | EP-A-0 157 052 (GENUS INC.) * Abstract * | 2,3 | |
| A | | 4 | |
| | ----- | | |

TECHNICAL FIELDS
SEARCHED (Int. Cl.4)

H 01 L

The present search report has been drawn up for all claims

| Place of search | Date of completion of the search | Examiner |
|---|---|---|
| THE HAGUE | 02-12-1988 | PHEASANT N.J. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 

& : member of the same patent family, corresponding
   document

EPO FORM 1503 03.82 (P0401)